(19) **Europäisches Patentamt / European Patent Office / Office européen des brevets**

(11) **EP 3 516 356 B1**

(12) **FASCICULE DE BREVET EUROPEEN**

(45) Date de publication et mention
de la délivrance du brevet:
**08.01.2025 Bulletin 2025/02**

(21) Numéro de dépôt: **17783913.1**

(22) Date de dépôt: **19.09.2017**

(51) Classification Internationale des Brevets (IPC):
**G01J 5/02** *(2022.01)* **G01J 5/20** *(2006.01)*
**G01J 5/24** *(2006.01)* **G01J 5/08** *(2022.01)*

(52) Classification Coopérative des Brevets (CPC):
**G01J 5/20; G01J 5/024; G01J 5/0853; G01J 5/24**

(86) Numéro de dépôt international:
**PCT/FR2017/052501**

(87) Numéro de publication internationale:
**WO 2018/055276 (29.03.2018 Gazette 2018/13)**

(54) **STRUCTURE DE DÉTECTION DE RAYONNEMENTS ÉLECTROMAGNÉTIQUES DE TYPE BOLOMÈTRE ET PROCÉDÉ DE FABRICATION D'UNE TELLE STRUCTURE**

**BOLOMETERSTRUKTUR ZUR DETEKTION VON ELEKTROMAGNETISCHER STRAHLUNG UND VERFAHREN ZUR HERSTELLUNG SOLCH EINER STRUKTUR**

**STRUCTURE, OF THE BOLOMETER TYPE, FOR DETECTING ELECTROMAGNETIC RADIATION AND PROCESS FOR MANUFACTURING SUCH A STRUCTURE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.09.2016 FR 1658921**

(43) Date de publication de la demande:
**31.07.2019 Bulletin 2019/31**

(73) Titulaire: **Commissariat à l'Energie Atomique et aux Energies Alternatives**
**75015 Paris (FR)**

(72) Inventeurs:
- **YON, Jean-Jacques**
  **38360 Sassenage (FR)**
- **FUXA, Etienne**
  **69480 Pommiers (FR)**

(74) Mandataire: **Brevalex**
**Tour Trinity**
**1 B Place de la Défense**
**92400 Courbevoie (FR)**

(56) Documents cités:
EP-A1- 2 995 916       WO-A1-2015/059227
DE-A1- 102014 221 609  DE-A1- 3 001 899
US-A1- 2010 244 029    US-A1- 2015 153 236

**Description**

## DOMAINE TECHNIQUE

L'invention concerne le domaine de l'optoélectronique et de la détection de rayonnement électromagnétique.

L'invention a ainsi plus précisément pour objet une structure de détection de rayonnements électromagnétiques de type bolomètre et un procédé de fabrication d'une telle structure.

## ÉTAT DE LA TECHNIQUE ANTÉRIEURE

Afin de détecter les rayonnements électromagnétiques, notamment dans la gamme de longueurs d'onde de l'infrarouge, il est connu d'utiliser des structures de détection de rayonnements électromagnétiques de type bolomètre.

Une telle structure comporte :

- un élément absorbant configuré pour absorber le rayonnement électromagnétique, généralement fourni sous la forme d'une membrane suspendue,
- un transducteur présentant une caractéristique qui varie avec la température, le transducteur étant associé à l'élément absorbant afin de permettre une détection de l'élévation de température dudit élément absorbant lors de l'absorption du rayonnement électromagnétique.

Classiquement, le transducteur est fourni par une couche présentant des propriétés de thermistance, telle qu'une couche d'un oxyde métallique sélectionné dans le groupe comportant les oxydes de vanadium VOx, les oxydes de nickel NiOx, les oxydes de titane TiOx, ou une couche de silicium amorphe aSi.

Néanmoins, avec un tel transducteur et avec une telle configuration, de telles structures ne peuvent être intégrées sous forme de matrice dans un composant présentant un pas de réseau inférieur à 10 $\mu$m. En effet, afin de préserver une sensibilité acceptable, la surface de l'élément absorbant doit être suffisante en raison de la sensibilité limitée des couches d'oxyde métallique utilisées en tant que transducteur, le coefficient de température ne dépassant pas les 2 à 2,5 %.K$^{-1}$ avec de telles couches.

Afin de fournir des structures de détection de type bolomètre présentant une sensibilité compatible avec une intégration dans des composants présentant des pas de réseau inférieurs à 10 $\mu$m, plusieurs pistes ont été envisagées.

Parmi celles-ci, on peut notamment citer la possibilité enseignée par le document US 7489024 qui propose de substituer le transducteur par un transistor de type MOS-FET fonctionnant en régime de faible inversion. En effet, une telle substitution permet d'aboutir à un coefficient de température pouvant aller jusqu'à 10%.K$^{-1}$.

Néanmoins, la mise en oeuvre proposée dans le document US 7489024 présente, malgré un coefficient de température optimisé, un nombre important d'inconvénients qui rend ce type de structure incompatible avec une intégration dans des composants présentant des pas de réseau inférieur à 10 $\mu$m.

En effet, de par sa conception, la structure décrite dans le document US 7489024 utilise des couches réalisées en dioxyde de silicium en tant qu'élément absorbant. Ces couches, de par leur fonction, doivent présenter une épaisseur significative. Il en résulte donc une inertie thermique importante et donc un temps de réponse dégradé. De plus, ces couches sont également fournies au niveau de bras d'isolation qui isolent la structure du reste du composant qu'elle équipe. Une telle promiscuité engendre une déperdition vers le reste du composant d'une partie de la chaleur générée par l'absorption du rayonnement électromagnétique.

Pour ces raisons et afin de conserver une sensibilité acceptable, les travaux des inventeurs de la structure décrite dans US 7489024, publiés notamment dans le journal scientifique « IEEE translation on Electron devices » volume 56 numéro 9 pages 1935 à 1942 en 2009, n'ont pas permis d'obtenir des structures dont le dimensionnement soit compatible avec une intégration sous forme de matrice dans un composant présentant un pas de réseau inférieur à 10 $\mu$m. En effet, la surface minimale requise pour une telle structure est 45 $\mu$m par 46 $\mu$m.

D'autres exemples de l'état de la technique sont fournis par les documents US20150153236, EP2995916, WO2015059227, DE3001899, DE102014221609 et US20100244029.

## EXPOSÉ DE L'INVENTION

L'invention a pour objet de remédier à cet inconvénient et a ainsi pour objet de fournir une structure de type bolomètre apte à être intégrée sous forme de matrice dans un composant présentant un pas de réseau inférieur à 10 $\mu$m.

L'invention concerne à cet effet une structure de détection de type bolomètre pour la détection d'un rayonnement électromagnétique telle que définie dans la revendication 1. Avec un élément absorbant sous la forme d'une portion de la première électrode de grille métallique, le fonctionnement de la structure s'en trouve optimisé. En effet, de par ces inégalités, la première portion métallique présente une impédance proche de celle du vide qui est de l'ordre 377 $\Omega$, ceci pour des épaisseurs relativement faibles de l'ordre de 10 nm. L'élément absorbant n'a donc pas besoin d'avoir une épaisseur importante pour obtenir une absorption supérieure à 85%. On réduit ainsi par rapport à l'art antérieur significativement la masse de l'élément absorbant nécessaire et son inertie. Ainsi la structure qui présente une faible inertie et une sensibilité optimisée par rapport aux structures de l'art antérieur. Cette sensibilité est ainsi particulièrement adaptée pour une intégration de la structure sous forme de matrice dans un composant présentant un pas de réseau inférieur à 10 μm.

Avantageusement l'épaisseur de la première portion métallique respecte les inégalités suivantes :

$$170\,\Omega \leq \frac{\rho}{Ep} \leq 700\,\Omega.$$

De cette manière il est possible d'obtenir une absorption supérieure à 90%.

Idéalement, l'épaisseur de la première portion métallique respecte les inégalités suivantes :

$$320\,\Omega \leq \frac{\rho}{Ep} \leq 420\,\Omega$$

$\frac{\rho}{Ep}$ peut être sensiblement égale à 377 Ω, c'est-à-dire compris entre 360 Ω et 380 Ω.

On peut noter qu'une telle configuration peut notamment être obtenue avec une portion métallique en nitrure de titane TiN de 10 nm d'épaisseur.

On peut noter qu'avec une troisième zone séparant l'une de l'autre la première et la deuxième zone, la troisième zone s'interpose entre la première et la deuxième zone.

Par type de conductivité dans lequel la troisième zone est sensiblement vide de porteurs, il doit être entendu ci-dessus et dans le reste de ce document que la troisième zone présente un type de conductivité et une épaisseur tels que, en l'absence de polarisation de la structure de détection, la troisième zone est sensiblement vide de porteurs. Bien entendu, en fonctionnement et lors de l'application d'une polarisation sur l'électrode de grille, la création du canal de conduction permet de peupler la troisième zone de porteurs du premier type de conductivité. On peut noter que pour l'homme du métier l'indication selon laquelle « la troisième zone est déplétée » est synonyme d'un tel type de conductivité dans lequel la troisième zone est sensiblement vide de porteurs.

Par transistor MOS-FET, terminologie généralement utilisée par l'homme du métier, il est entendu ci-dessus et dans le reste de ce document, transistor à effet de champ du type métal/oxide/semconducteur. En effet, le sigle MOS-FET a pour origine la terminologie anglaise « Metal-Oxyde-Semiconductor Field Effect Transistor ».

La première portion métallique de la première électrode de grille peut être réalisée dans un métal du type « milieu-de-gap » pour la troisième zone, la première portion métallique étant préférentiellement dans un métal choisie dans le groupe comportant les nitrures de titane, les nitrures de tantale et les siliciures de molybdène pour une troisième zone réalisée en silicium, la première portion métallique étant avantageusement réalisée dans un nitrure de titane pour une troisième zone réalisée en silicium.

Les inventeurs ont découvert qu'avec une telle adaptation du travail de sortie de la première portion métallique vis-à-vis de la troisième, le transistor peut fonctionner avec une tension d'inversion relativement faible puisque des tensions source-grille entre 50 mV et 75 mV sont accessibles tout en offrant une sensibilité élevée du courant du transistor à la température. Ainsi, l'effet Joule lié à la polarisation de la structure reste contenu et perturbe peu le fonctionnement de la structure.

On entend ci-dessus et dans le reste de ce document par « métal du type milieu-de-gap » que le métal est choisi de manière à présenter, en absence de polarisation de la structure, son énergie de Fermi dans la zone de bande interdite de la troisième zone et plus précisément au voisinage du milieu de la bande interdite de la troisième zone, typiquement à un niveau d'énergie distant du milieu de la bande interdite dans une gamme comprise entre -25% et +25% du gap de la bande interdite. Une telle configuration de grille est généralement connue par l'homme du métier sous la dénomination anglaise de « mid-gap ». Ainsi dans le cas où la troisième zone est réalisée en silicium, les « métals du type milieu-de-gap » comportent notamment les nitrures de titane, les nitrures de tantale et les siliciures de molybdène.

La première électrode de grille peut être en court-circuit avec l'une de la première et la deuxième zone.

Avec une telle configuration, permise par la possibilité de fonctionnement à faible tension d'inversion pour une portion métallique de la première électrode de grille est réalisée dans un métal du type « milieu-de-gap », la structure ne nécessite que deux pistes de conduction pour être polarisée. Les chemins de conduction électrique, et donc thermique, entre l'électronique de lecture et le transistor sont réduits au minimum. Il est donc possible de fournir une isolation thermique entre le transistor et l'électronique de lecture particulièrement optimisée.

La première zone est entourée par la troisième zone, la troisième zone étant entourée par la deuxième zone.

Avec une telle configuration, la première électrode de grille présente un rapport élevé de la largeur de grille à la longueur de grille, largeur et longueur de l'électrode de grille devant être considérés comme il est d'usage de les exprimer dans le formalisme décrivant le fonctionnement des MOS-FET, c'est à dire relativement à la direction de circulation du courant entre la première et la deuxième zone du transistor. Un tel rapport permet d'augmenter la sensibilité du courant du transistor à la température. Avec une telle configuration, un tel rapport peut en outre être obtenu avec une longueur de l'électrode de grille particulièrement importante pour optimiser le rapport signal sur bruit de la structure puisque le bruit est directement relié à la surface de l'électrode de grille. On note ainsi qu'avec une telle configuration, il est possible d'obtenir une longueur de la première électrode de grille supérieure à 0,5 μm. On note aussi qu'avec une telle configuration on limite la première zone du transistor à une unique portion et la deuxième zone du transistor à une autre unique portion. La grille est donc de facto imposante et la forme en anneau est celle qui permet d'optimiser à la fois sa surface et le rapport de sa largeur à sa longueur dans l'espace imposé par le pixel.

Le transistor peut comporter en outre :

- une quatrième et cinquième zone, la quatrième zone étant du premier type de conductivité et la cinquième zone étant d'un type de conductivité sélectionné dans le groupe comportant un deuxième type de conductivité opposé au premier type de conductivité et un type de conductivité dans lequel la troisième zone est sensiblement vide de porteurs,
- une troisième électrode de grille agencée pour polariser la cinquième zone,

dans laquelle la cinquième zone sépare l'une de l'autre la deuxième et la quatrième zone, et dans laquelle la troisième électrode de grille comporte au moins une deuxième portion métallique formant un deuxième élément absorbant, ladite deuxième portion métallique présentant une épaisseur Ep respectant l'inégalité suivante :

$$150\,\Omega \le \frac{\rho}{Ep} \le 700\,\Omega$$

avec ρ la résistivité du matériau métallique formant ladite deuxième portion métallique.

Un ensemble formé par la troisième, la deuxième et la cinquième zone peut séparer l'une de l'autre la première et la quatrième zone.

La cinquième zone peut entourer la deuxième zone, la quatrième zone entourant la cinquième zone.

La première, la troisième, deuxième, la cinquième et la quatrième zone peuvent se succéder selon une première direction.

Ainsi, avec de telles caractéristiques, les surfaces de grille de la première et de la troisième électrode de grille s'additionnant, la surface totale de grille est particulièrement importante. Le rapport signal sur bruit peut donc, de ce fait, être particulièrement optimisé pour une telle structure.

On peut noter qu'avec une cinquième zone séparant l'une de l'autre la deuxième et la quatrième zone, la troisième zone s'interpose entre la deuxième et la quatrième zone.

La troisième zone peut être du type de conductivité dans lequel la troisième zone est sensiblement vide de porteurs.

Avec une telle troisième zone, les effets parasites liés à un substrat à potentiel flottant, tels que ceux liés à l'effet Kink, sont contenus, voire absents. Il n'est donc pas nécessaire d'ajouter une connexion pour polariser le canal, c.a.d la troisième zone. L'isolation thermique du transistor n'est donc pas dégradée par une telle connexion de polarisation du canal.

Il peut être prévu une surface réfléchissante configurée pour former avec le premier élément absorbant une cavité quart d'onde.

De cette manière, la part du rayonnement électromagnétique non absorbée par le premier élément absorbant est réfléchie par la surface réfléchissante en direction du premier élément absorbant afin d'y être absorbé. Ce phénomène est d'autant plus amplifié en raison de la résonnance créée par la formation de la cavité quart d'onde.

La première électrode de grille peut être séparée de la troisième zone par une première et une deuxième couche isolante électriquement, l'une de la première et de la deuxième couche isolante électriquement étant réalisée en dioxyde de silicium, l'autre de la première et la deuxième couche isolante électriquement étant réalisée en isolant diélectrique à haute constante diélectrique.

De cette manière il est possible de fournir une épaisseur d'isolation entre la première électrode de grille et la troisième zone relativement faible tout en limitant la contribution du bruit 1/f lors du fonctionnement du transistor.

Il doit être entendu ci-dessus et dans le reste de ce document, par « isolant diélectrique à haute constante diélectrique », ou, selon la dénomination anglaise généralement employée par l'homme du métier, par matériau diélectrique « high-K », un matériau isolant dont la constante diélectrique est élevée par rapport à celle du dioxyde de silicium qui est égale à 3,9. Ainsi, un matériau diélectrique pourra être considéré comme un matériau à haute constante diélectrique s'il présente une constante diélectrique supérieure ou égale à au moins 1,5 fois, voire 2 à 3 fois, celle du dioxyde de silicium.

La structure peut comporter en outre un circuit de lecture configuré pour polariser le transistor et pour déterminer, à partir d'un courant de fonctionnement du transistor une élévation de température de l'élément absorbant,
le circuit de lecture et le transistor étant séparés l'un de l'autre par au moins un premier et un deuxième bras d'isolation comportant chacun au moins une piste conductrice pour polariser le transistor.

De cette manière, le contact thermique entre le transistor et le circuit de lecture est réduit au minimum. La structure présente donc une inertie thermique relativement faible et voit sa sensibilité préservée.

Chacune des pistes conductrices du premier et deuxième bras d'isolation peut être une piste métallique formant un troisième élément absorbant et présente une épaisseur Ep respectant l'inégalité suivante :

$$150\,\Omega \le \frac{\rho}{Ep} \le 700\,\Omega$$

avec ρ la résistivité du matériau métallique formant ladite deuxième portion métallique.

De cette manière, la part du rayonnement électromagnétique non absorbée par le premier élément absorbant peut être absorbée par les pistes conductrices et participer en partie à l'élévation de température du transistor.

Le transistor peut comporter en outre une deuxième électrode de grille sur une face du transistor qui est opposée à la première électrode de grille,

la deuxième électrode de grille comportant au moins une portion métallique un quatrième élément absorbant.

Une telle deuxième électrode de grille permet d'ajuster la tension seuil du transistor tout en en augmentant la surface d'élément absorbant. Le rapport signal sur bruit s'en trouve donc amélioré.

L'invention concerne également un procédé de fabrication d'une structure de détection tel que défini dans la revendication 11.

Un tel procédé permet de fournir une structure selon l'invention et donc de bénéficier des avantages qui y sont liés.

Lors de l'étape de formation de la première électrode de grille, la première portion métallique de la première électrode de grille peut être réalisée dans un métal du type « milieu-de-gap » pour la troisième zone, la première portion métallique étant préférentiellement dans un métal choisie dans le groupe comportant les nitrures de titane, les nitrures de tantale et les siliciures de molybdène pour une troisième zone réalisée en silicium, la première portion métallique étant avantageusement réalisée dans un nitrure de titane pour une troisième zone réalisée en silicium.

Ainsi la structure obtenue avec un tel procédé bénéficie des avantages liés à l'utilisation d'une première portion métallique du type « milieu-de-gap » et autorise donc un fonctionnement du transistor à faible tension d'inversion.

Il peut en outre être prévu des étapes de :

- formation d'un circuit de lecture configuré pour polariser le transistor et pour déterminer, à partir d'un courant de fonctionnement du transistor une élévation de température de l'élément absorbant,
- formation d'un premier et d'un deuxième bras d'isolation chacun des premier et deuxième bras d'isolation comportant au moins une piste conductrice,
- association ensemble du transistor, des premier et deuxième bras d'isolation et du circuit de lecture, de tel façon que le circuit de lecture est connecté électriquement au transistor par l'intermédiaire des pistes conductrices respectives des premier et deuxième bras d'isolation.

La structure ainsi fabriquée présente une isolation optimisée vis-à-vis du circuit de lecture, ceci notamment de par l'utilisation du premier et du deuxième bras d'isolation.

Lors de l'étape de fourniture du circuit de lecture, il peut être prévu une sous-étape de formation d'une surface de réflexion,

Lors de l'étape d'association ensemble du transistor, des premier et deuxième bras d'isolation et du circuit de lecture, la surface de réflexion peut présenter une disposition de manière à former avec la portion en nitrure de titane de la première électrode de grille une cavité quart d'onde.

Ainsi, la structure fabriquée bénéficie des avantages liés à une telle surface de réflexion.

## BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :

- les figures 1A à 1C illustrent schématiquement une structure selon l'invention avec en figure 1A une vue de dessus figurant en pointillés les différents éléments composant la structure, en figure 1B et 1C une vue en coupe de cette même structure selon respectivement l'axe B-B et l'axe A-A,
- les figure 2A et 2B illustrent schématiquement, ceci en cours de fabrication, les parties de la structure formant respectivement un circuit de lecture et un réflecteur, avec en figure 2A une vue de dessus et en figure 2B une vue en coupe selon l'axe C-C,
- les figures 3A et 3B illustrent schématiquement, ceci en cours de fabrication, les parties de la structure formant respectivement un élément absorbant et un transducteur, avec en figure 3A une vue de de dessus et en figure 3B une vue en coupe selon l'axe D-D,
- les figures 4A et 4B illustrent schématiquement, ceci en cours de fabrication, les parties de la structure formant respectivement des bras isolants et le réflecteur, avec en figure 4A une vue de de dessus et en figure 4B une vue en coupe selon l'axe E-E,
- la figure 5 illustre schématiquement l'organisation en matrice de quatre structures selon l'invention lorsqu'elles équipent un composant,
- la figure 6 illustre schématiquement en vue de dessus une structure selon un deuxième mode de réalisation dans lequel le transducteur comporte cinq zones.

Des parties identiques, similaires ou équivalentes des différentes figures portent les mêmes références numériques de façon à faciliter le passage d'une figure à l'autre.

Les différentes parties représentées sur les figures ne sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## EXPOSÉ DÉTAILLÉ DE MODES DE RÉALISATION PARTICULIERS

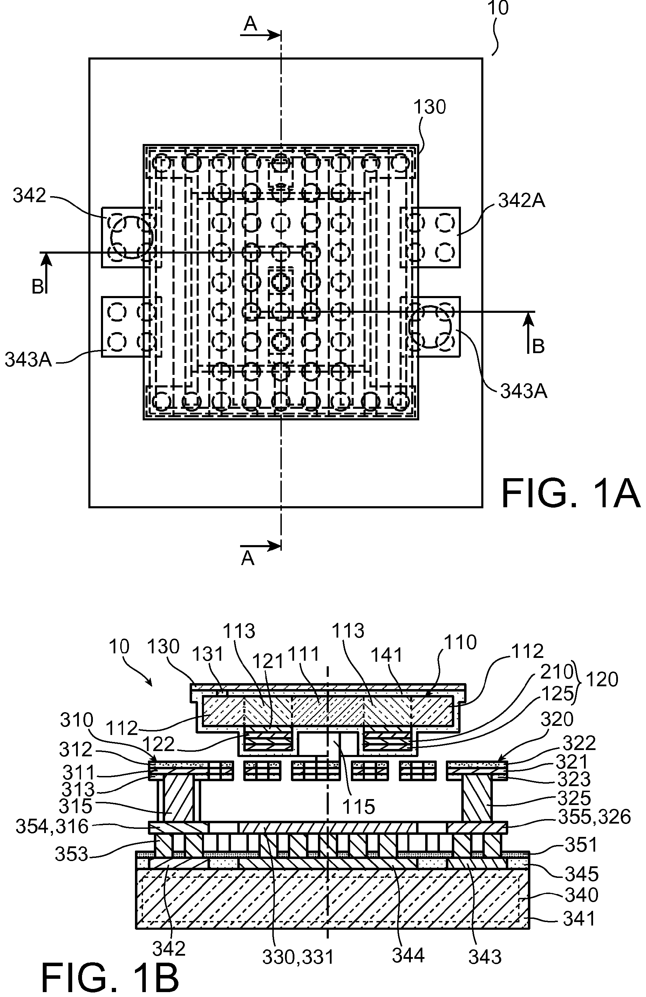

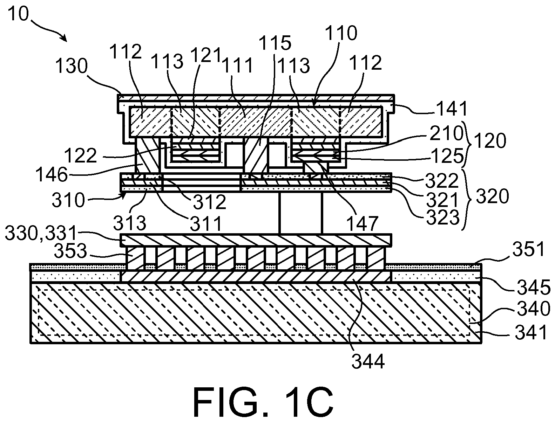

La figure 1A illustre schématiquement une structure de détection 10 de type bolomètre selon l'invention, une telle structure de détection 10 étant adaptée pour la détection d'un rayonnement électromagnétique.

Une telle structure de détection 10 vise plus particulièrement la détection de rayonnements électromagnétiques dans la gamme de longueurs d'onde des infrarouges. Ainsi, les différentes valeurs indiquées dans les modes de réalisation décrits ci-après concernent cette application pratique, dans laquelle la gamme de longueurs d'onde visée est l'infrarouge lointain, c'est-à-dire entre 8 et 12 $\mu$m. Bien entendu, l'homme du métier est parfaitement à même, à partir de la présente divulgation, d'adapter ces valeurs afin de permettre à l'aide d'une telle structure de détection 10 la détection optimisée de rayonnements électromagnétiques dans une gamme de longueurs d'onde autre que celle des infrarouges.

Une telle structure de détection 10 comporte :

- un transistor 100 du type MOS-FET comportant :

  o au moins une première et au moins une deuxième zone 111, 112 d'un premier type de conductivité,
  o au moins une troisième zone 113 séparant l'une de l'autre la première et la deuxième zone 111, 112, la troisième zone 113 étant d'un type de conductivité dans lequel la troisième zone est sensiblement vide de porteurs, autrement dit la troisième zone 113 est totalement déplétée,
  o une première électrode de grille 120 agencée pour polariser la troisième zone 113, la première grille comportant une première couche d'absorption 210 en nitrure de titane TiN formant le premier élément absorbant,
  o une deuxième électrode de grille 130 optionnelle agencée sur la face de la troisième zone qui est opposée à la première électrode de grille 120 pour polariser la troisième zone 113,

- un premier et un deuxième bras d'isolation 310, 320 comportant respectivement une première et une deuxième piste de conduction 311, 321 pour permettre la polarisation du transistor 100, la première piste 311 étant connectée à la deuxième zone 112, la deuxième piste 321 étant connectée à la première et à la troisième zone 111, 113 en les mettant en court-circuit,
- une surface de réflexion 330, 331 optionnelle disposée de manière à former avec la première couche d'absorption une cavité quart d'onde,
- un circuit de lecture 340 dont seul le substrat 341 est figuré, le circuit de lecture 340 étant connecté électriquement aux première et deuxième pistes de conduction 311, 321 par l'intermédiaire de respectivement d'un premier, deuxième, troisième et quatrième plot de collage 354, 355, 316, 326.

On notera que dans une telle configuration, la première zone 111 forme le drain du transistor, la deuxième zone 112 forme la source du transistor et la troisième zone 113 le canal du transistor 100. Ainsi le transistor 100, dans ce premier mode de réalisation, fonctionne en faible insertion, le drain et l'électrode de grille étant en court-circuit et les tensions source-drain $V_{SD}$ et source grille $V_{SG}$ étant égales.

Une telle structure de détection 10 peut être fabriquée en quatre étapes différentes, une première étape lors de laquelle est fourni le circuit de lecture 340, une deuxième étape lors de laquelle sont fournis le transistor 100 et sa première électrode de grille 120 formant le premier élément absorbant, une troisième étape lors de laquelle sont formés les bras d'isolation 310, 320 en contact avec le transistor 100 et une quatrième étape lors de laquelle l'ensemble transistor 100/bras d'isolation 310, 320 est collé au circuit de lecture 340. Lors de cette quatrième étape, il est également possible de réaliser la deuxième électrode de grille 130.

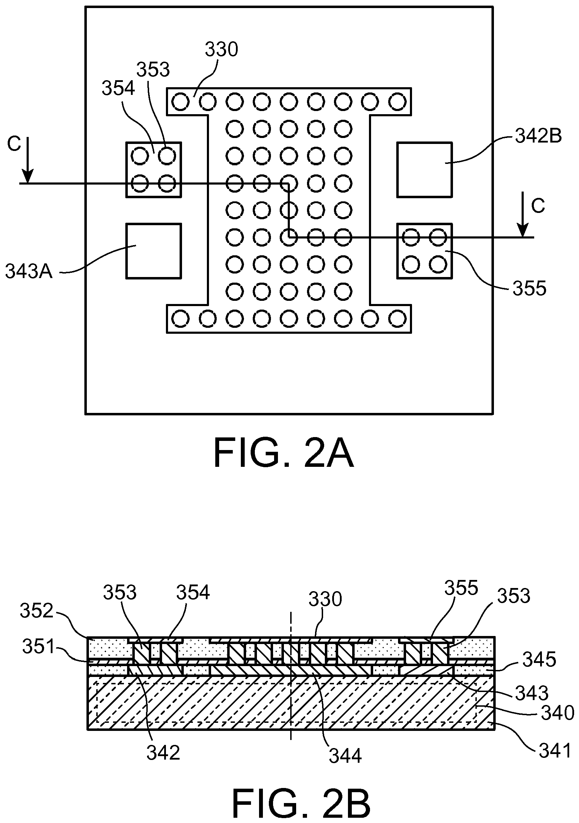

Les figures 2A et 2B illustrent ainsi le circuit de lecture 340 en cours de fabrication lors de l'étape de fourniture du circuit de lecture.

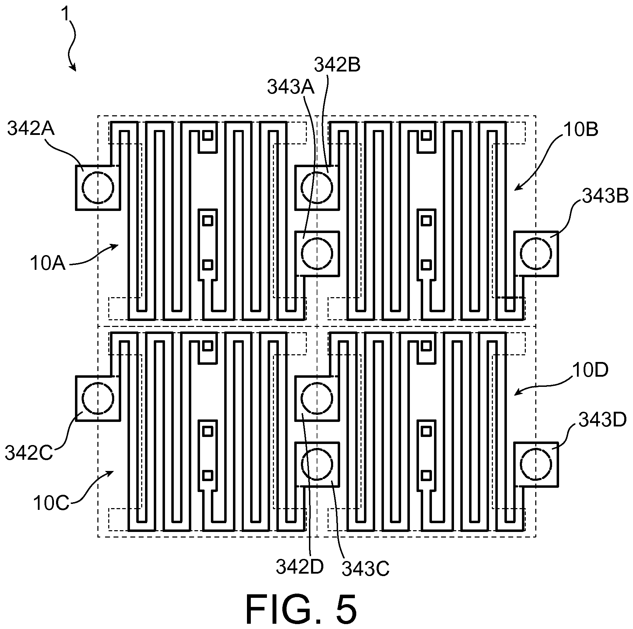

Ainsi, le circuit de lecture 340 est, comme illustré sur les figures 2A et 2B, aménagé dans un support semiconducteur 341, tel qu'un substrat en silicium, dans lequel sont ménagés les composants du circuit de lecture. Le circuit de lecture 340 est configuré pour polariser le transistor et pour déterminer, à partir d'un courant de fonctionnement du transistor 100 une élévation de température de la première électrode de grille 120. Un tel circuit de lecture 340 est uniquement figuré au moyen de pointillés représentant son emplacement dans le support 341. Un tel circuit de lecture 340 est d'un type connu de l'homme du métier et peut ainsi aussi bien être un circuit de lecture dédié à un seul transistor 100, qu'un circuit mutualisé pour un groupe ou pour tous les transistors équipant un composant 1 (se référer à la figure 5) ou encore un circuit de lecture composé d'une partie dédiée à un seul transistor et d'une partie mutualisée pour un groupe ou pour tous les transistors équipant un composant 1. De tels circuits de lecture, généralement de technologie MOS, étant connus de l'homme du métier, ils ne sont pas décrits plus précisément dans ce document.

Afin d'assurer la connexion entre le circuit de lecture 340 et le transistor 100, le circuit de lecture 340 comporte, sur une face de connexion du support semiconducteur 341, un premier et un deuxième plot de connexion 342, 343. Le premier et le deuxième plot de connexion 342, 343 sont réalisés dans un matériau métallique adapté pour former un contact ohmique avec le circuit de lecture. Ainsi, un tel matériau métallique peut être, par exemple, réalisé en cuivre. Le premier et le deuxième plot de connexion 342, 343, dans le cadre d'une application pratique de l'invention, peuvent présenter une surface de 1 $\mu$m par 1 $\mu$m. On peut également noter que sur la figure 2A sont également montrés les premier et deuxième plots de connexion 342B, 343A de respectivement une première et une deuxième structure de détection adjacente.

La face de connexion du support semiconducteur 341 est également munie, comme illustré sur la figure 2B, d'une couche métallique 344 pour permettre la formation d'une première partie 330 de la surface de réflexion 330, 331. Ainsi, la couche métallique 344 s'étend sur une majeure partie de la surface de la structure de détection 10. On notera que dans l'application pratique de l'invention, la surface occupée par la structure de détection 10 peut être une surface de 5 μm par 5 μm.

La face de connexion qui n'est pas revêtue par le premier et le deuxième plot de connexion 342, 343 et par la couche métallique 344 est recouverte d'une première couche de passivation 345. On peut noter que selon une possibilité de l'invention, une telle couverture de la face connexion peut être fournie par un procédé Damascène. La première couche de passivation 345 est réalisée dans un matériau diélectrique tel qu'un dioxyde de silicium $SiO_2$ ou un nitrure de silicium $Si_3N_4$.

La première couche de passivation 345, les premier et deuxième plots de connexion 342, 343 et la couche métallique 344 sont recouverts par une première couche d'arrêt 351. La première couche d'arrêt 351 est elle-même recouverte d'une première couche sacrificielle 352. La première couche sacrificielle 352 et la première couche d'arrêt 351 sont réalisées dans des matériaux autorisant une gravure sélective, préférentiellement chimique, de la première couche sacrificielle 352, la première couche d'arrêt 351 permettant donc d'arrêter la gravure afin de protéger notamment la première couche de passivation 345. Ainsi, classiquement, la première couche sacrificielle 352 peut être réalisée en dioxyde de silicium $SiO_2$, la première couche d'arrêt 351 étant alors réalisée en alumine $Al_2O_3$ ou en nitrure d'aluminium AlN, la gravure sélective étant alors obtenue par une attaque chimique à l'acide fluorhydrique, préférentiellement en phase vapeur.

La première couche d'arrêt 351 et la première couche sacrificielle 352 sont toutes deux traversées, sur leur épaisseur et au niveau des premier et deuxième plots de connexion 342, 343 et de la couche métallique 344, par des piliers métalliques 353 formant, pour les premier et deuxième plots de connexion 342, 343, des via de connexion. Le matériau métallique des piliers métalliques 353 peut être du cuivre. Dans une application pratique de l'invention, les piliers métalliques 353 présentent une section circulaire dont le diamètre est sensiblement égal à 0,3 μm. Ainsi chacun des premier et deuxième plots de connexion 342, 343 est en contact avec quatre piliers métalliques.

La première couche sacrificielle 352 inclut également :

- un premier et un deuxième plot de collage 354, 355 associés respectivement aux premier et deuxième plots de connexion 342, 343 au moyen des piliers métalliques 353,
- la première partie 330 de la surface de réflexion 330, 331 associée à la couche métallique 344 au moyen des piliers métalliques 353.

De cette manière, les premier et deuxième plots de collage 354, 355 sont connectés électriquement à respectivement le premier et le deuxième plot de connexion 342, 343, la première partie 330 de la surface de réflexion 330, 331 étant connectée mécaniquement à la couche métallique 344 au moyen des piliers métalliques 353.

Le premier et le deuxième plot de collage 354, 355 et la couche réfléchissante 330 affleurent de la première couche sacrificielle 352 sur la face de la première couche sacrificielle 352 qui est opposée à la première couche d'arrêt 351.

Dans une application pratique de l'invention, les plots de collage peuvent présenter, par exemple, une surface de 1 μm par 1 μm.

Ainsi, l'étape de fourniture d'un tel circuit de lecture comporte les sous-étapes suivantes :

- fourniture du substrat 341 dans lequel a été préalablement réalisé le circuit de lecture 340,
- formation de la première couche de passivation 345,
- formation du premier et du deuxième plot de connexion 342, 343 et de la couche métallique 344, dans l'épaisseur de la couche de passivation 345,
- dépôt de la première couche d'arrêt 351 en contact avec les premier et deuxième plots de connexion 342, 343, de la couche métallique et de la première couche de passivation 345,
- dépôt de la première couche sacrificielle 352 en contact avec la première couche d'arrêt 351,
- ménagement de passages traversants dans la première couche d'arrêt 251 et dans la première couche sacrificielle 352, lesdits passages traversants débouchant sur les premier et deuxième plots de connexion 342, 343 et la couche métallique 344 pour permettre la formation des piliers métalliques 353,
- ménagement d'ouvertures superficielles dans la première couche sacrificielle 352 correspondant aux premier et deuxième plots de collage 354, 355 et à la première partie 330 de la surface de réflexion 330, 331,
- dépôt d'un matériau métallique dans les passages traversants pour former les piliers métalliques 353, les premier et deuxième plots de collage 354, 355 et la première partie 330 de la surface de réflexion 330, 331.

On notera qu'il est possible de prévoir, afin de favoriser un collage moléculaire, une sous-étape de planarisation de la première couche sacrificielle 352, de la première partie 330 de la surface de réflexion 330, 331 et des premier et deuxième plots de collage 354, 355.

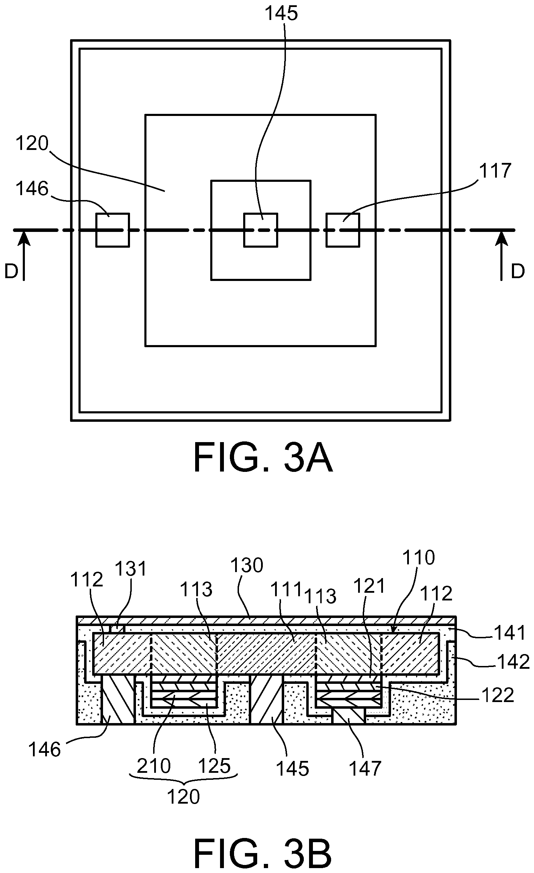

Les figures 3A et 3B illustrent le transistor 100 en cours de fabrication lors de l'étape de fourniture du transistor 100 et de sa première électrode de grille 120 formant le premier élément absorbant. On peut noter que sur les figures 3A et 3B le transistor 100 comporte la deuxième électrode de grille 130 et une première portion deuxième couche d'arrêt 141 recouvrant les première, deuxième et troisième zone 111, 112, 113 sur leur face qui est opposée à la première électrode de grille 120. Dans une variante préférée de l'invention, la deuxième électrode de grille 130 et la première portion deuxième couche d'arrêt 141 recouvrant les première, deuxième et troisième zone 111, 112, 113 peuvent néanmoins être formée ultérieurement lors de l'étape de collage de l'ensemble transistor 100 /bras d'isolation 310, 320 avec circuit de lecture 340. On notera que la première et la deuxième zone 111, 112 et la première électrode de grille 120 sont recouvertes, sur la face par laquelle elles sont connectées aux première et deuxième pistes de conduction 321, par une deuxième portion de la couche d'arrêt 141.

On peut ainsi voir sur la figure 3A qui illustre une vue de face du transistor 100 selon la face par laquelle le transistor 100 doit être relié au circuit de lecture 340. On peut ainsi voir que les première, deuxième et troisième zones 111, 112, 113 du transistor 100 sont concentriques, la première zone 111 est entourée par la troisième zone 113, la troisième zone 113 étant entourée par la deuxième zone 112. On peut ainsi voir sur la figure 3A que la première zone 111 occupe une surface carrée centrale, la troisième zone 113 occupant une surface carrée évidée de la première zone 111, la deuxième zone occupant le reste de la surface du transistor 100.

Les première, deuxième, troisième zones 111, 112, 113 sont toutes trois formées dans une couche semiconductrice 110 en silicium. La première et la deuxième zone 111, 112 présentent un premier type de conductivité alors que la troisième zone 113 est une zone totalement déplétée. Une telle déplétion de la troisième zone 113 peut être obtenue au moyen d'un substrat de silicium sur oxyde, ou SOI pour le sigle anglais de « silicon on insulator », dont l'épaisseur de la couche de silicium sur isolant a été amincie par oxydation thermique et désoxydation à une épaisseur comprise entre 15 et 50 nm préférentiellement entre 25 et 50 nm, voire sensiblement égale à 50 nm.

Bien entendu, si une telle déplétion totale de la troisième zone 113 est avantageuse, il est également envisageable, sans que l'on sorte du cadre de l'invention, que la troisième zone 113 soit d'un deuxième type de conductivité opposé au premier type de conductivité.

La troisième zone 113 est recouverte de la première électrode de grille 120 et est séparée de cette dernière par une première et une deuxième couche isolante 121, 122 électriquement. Afin de minimiser la tension de fonctionnement du transistor, la première couche isolante 121, en contact de la troisième zone, est réalisée en dioxyde de silicium SiOz tandis que la deuxième couche isolante 122, en contact avec la première couche isolante 121, est réalisée dans un isolant diélectrique à haute constante diélectrique tel que l'oxyde d'Hafnium. On peut noter que dans une application pratique de l'invention, la première couche isolante 121 peut présenter une épaisseur de 9 nm, tandis que la deuxième couche isolante 122 réalisée en oxyde d'hafnium présente une épaisseur de 3 nm.

La première électrode de grille 120, en contact de la deuxième couche d'isolant 122, peut comporter la première couche d'absorption 210 et une première couche conductrice 125. La première couche d'absorption 210 en contact avec la deuxième couche isolante 122 est réalisée en nitrure de titane TiN tandis que la première couche conductrice 125 en contact avec la première couche d'absorption 210 est réalisée dans un matériau adapté pour permettre une connexion ohmique entre la première électrode de grille 120 et la deuxième piste de conduction 321 du deuxième bras d'isolation 320. Dans une application pratique de l'invention, la première couche d'absorption 210 présente une épaisseur de 10 nm, tandis que la première couche de conduction 125 est réalisée en silicium polycristallin Si dopé et présente une épaisseur de 70 nm.

Avec une telle configuration, la première électrode de grille 120 forme une électrode de grille dite « milieu-de-gap ». En effet, l'utilisation d'une première couche d'absorption en nitrure de titane TiN en contact avec les couches isolantes de grille permet d'obtenir une différence de travaux de sortie entre le silicium de la troisième zone et le métal de l'électrode de grille telle que la tension de seuil du transistor 100 soit faible. Ainsi, cette configuration autorise un fonctionnement du transistor avec une tension grille/source comprise entre 2KT/q et 3KT/q (K étant la constante de Bolzmann, T la température de fonctionnement du transistor et q la charge élémentaire), c'est-à-dire entre 50 et 75 mV à la température ambiante, c'est à 300 K. De plus, dans le cas où l'épaisseur de la première couche d'absorption 210 est sensiblement égale à 10 nm comme cela est le cas dans l'application pratique de l'invention, la résistance de la première couche d'absorption 210 est sensiblement adaptée à celle du vide, c'est-à-dire 377 Ohm, ce qui favorise l'absorption du rayonnement électromagnétique par la première couche d'absorption 210.

En variante , d'autres configurations de l'électrode de grille sont envisageables dans le cadre de l'invention. Ainsi la première électrode de grille 120 peut comporter en lieu et place de la première couche d'absorption en nitrure de titane, une première portion métallique formant premier élément absorbant, ladite première portion métallique présentant une épaisseur Ep respectant les inégalités suivantes :

$$150 \, \Omega \leq \frac{\rho}{Ep} \leq 700 \, \Omega$$

avec $\rho$ la résistivité du matériau métallique formant ladite portion métallique.

Afin de fournir une absorption du rayonnement électromagnétique, cette même première portion métallique peut avantageusement respecter les inégalités suivantes :

$$320 \, \Omega \leq \frac{\rho}{Ep} \leq 420 \, \Omega$$

De manière encore plus avantageuse $\frac{\rho}{Ep}$ peut être sensiblement égale à 377 $\Omega$, c'est-à-dire compris entre 360 $\Omega$ et 380 $\Omega$.

Selon cette variante, le matériau métallique de la première portion métallique peut être un métal du type « milieu-de-gap » pour la troisième zone 113, la première portion métallique étant préférentiellement dans un métal choisie dans le groupe comportant les nitrures de titane, les nitrures de tantale et les siliciures de molybdène pour une troisième zone réalisée en silicium. On peut également noter que selon une possibilité moins avantageuse de l'invention dans laquelle le matériau métallique de la première portion métallique n'est pas un métal du type « milieu-de-gap », la première portion métallique peut être réalisée dans un alliage d'aluminium et de titane.

Comme illustré sur la figure 3B, l'ensemble formé par les première, deuxième et troisième zones 111, 112, 113, les première et deuxième couches isolantes 121, 122, la première couche d'absorption 210 et la couche de conduction 125 est entourée d'une deuxième couche d'arrêt 141. La deuxième couche d'arrêt 141 est elle-même revêtue, sur sa face qui recouvre la première électrode de grille 120 et les première et deuxième zones 111, 112, d'une deuxième couche sacrificielle 142. La deuxième couche d'arrêt 141 et la deuxième couche sacrificielle sont toutes deux traversées par un premier, un deuxième et un troisième via conducteur 145, 146, 147 débouchant respectivement sur la première zone 111, la deuxième zone 112 et la première électrode de grille 120. De la même manière que la première couche sacrificielle 352 et la première couche d'arrêt 351, la deuxième couche sacrificielle 142 et la deuxième couche d'arrêt 141 sont réalisées dans des matériaux autorisant une gravure sélective, préférentiellement chimique, de la deuxième couche sacrificielle 142, la deuxième couche d'arrêt 141 permettant donc d'arrêter la gravure. Ainsi, la deuxième couche sacrificielle 142 peut être réalisé en dioxyde de silicium $SiO_2$, la deuxième couche d'arrêt 141 étant alors réalisée en alumine $Al_2O_3$ ou en nitrure d'aluminium AlN.

Afin de fournir un contact optimisé entre chacun des premier, deuxième et troisième via conducteurs 145, 146, 147 et la première et la deuxième zone 111, 112 et la première électrode de grille 120, chacun des premier, deuxième et troisième via conducteurs 145, 146, 147 comportent une portion de contact en titane Ti de 30 nm d'épaisseur, une portion intermédiaire en nitrure de titane TiN de 60 nm d'épaisseur et une portion longitudinale en tungstène W.

Comme illustré sur la figure 3B, la deuxième couche d'arrêt 141 peut également être revêtue, sur sa face opposée à la deuxième couche sacrificielle 142, de la deuxième électrode de grille 130. Selon cette possibilité, la deuxième couche d'arrêt 142 forme un isolant électrique qui permet d'isoler électriquement la deuxième électrode de grille des première, deuxième et troisième zones 111, 112, 113. Comme cela a été précisé plus haut, selon une variante préférée de l'invention, la première portion la deuxième couche sacrificielle 142 et la deuxième électrode de grille 130 peuvent être formées lors de la quatrième étape. Ainsi, la première portion la deuxième couche sacrificielle 142 et la deuxième électrode de grille 130 sont décrites plus précisément en lien avec la quatrième étape.

Ainsi, l'étape de fourniture d'un tel transistor comporte les sous-étapes suivantes :

- fourniture du substrat du type SOI, non illustré
- gravure et amincissement du substrat afin de fournir une couche de silicium 110 totalement déplétée,
- dépôt de la première couche isolante 121, en contact avec la couche de silicium,
- dépôt de la deuxième couche isolante 122, en contact avec la première couche isolante 121,
- dépôt de la première couche d'absorption 210 en contact de la deuxième couche isolante 122,
- dépôt de la couche conductrice 125 en contact de la première couche d'absorption 210,
- gravure sélective de la couche conductrice 125, de la première couche d'absorption 210, de la couche isolante 122 et de la première couche isolante 121 de manière à former la première électrode de grille 120,
- implantation de la couche de silicium d'éléments dopant du premier type de conductivité afin de former la première et la deuxième zone, la première électpde de grille permettant de protéger la troisième zone 113 pendant l'implantation,
- dépôt de la deuxième couche d'arrêt 141,
- dépôt d'au moins la deuxième portion de la deuxième couche sacrificielle 142,
- ouverture d'un premier, deuxième et troisième passage dans la deuxième portion deuxième couche d'arrêt 141 et dans la deuxième couche sacrificielle 142 correspondant respectivement au premier, deuxième et troisième via, les premier, deuxième et troisième passages débouchant respectivement dans la première et deuxième zone 111, 112 et la première électrode de grille 120,
- dépôt successif dans les premier, deuxième et troisième passages de la première portion de contact en titane Ti, de la portion intermédiaire en nitrure de titane TiN et de la portion longitudinale en tungstène W.

Dans le cas où selon une variante non préférée de l'invention, la première portion de la deuxième couche d'arrêt 141 et la troisième électrode de grille sont formée lors de cette quatrième étape, la première portion de la couche sacrificielle 142 est formée simultanément à la deuxième portion de la couche sacrificielle 142 lors de l'étape de dépôt d'au moins la deuxième portion de la deuxième couche sacrificielle 142 et l'étape de fourniture d'un tel transistor comporte en outre les sous-étapes suivantes :

- ouverture d'un passage traversant 131, illustré sur la figure 1B, dans la première portion de de la deuxième couche sacrificielle 142, ledit passage traversant débouchant dans la deuxième zone 112,
- formation de la deuxième électrode de grille 130 en contact avec la première portion de la deuxième couche sacrificielle 142, un via conducteur étant alors formé dans le passage traversant 131 entre la deuxième électrode de grille 130 et la deuxième zone 112.

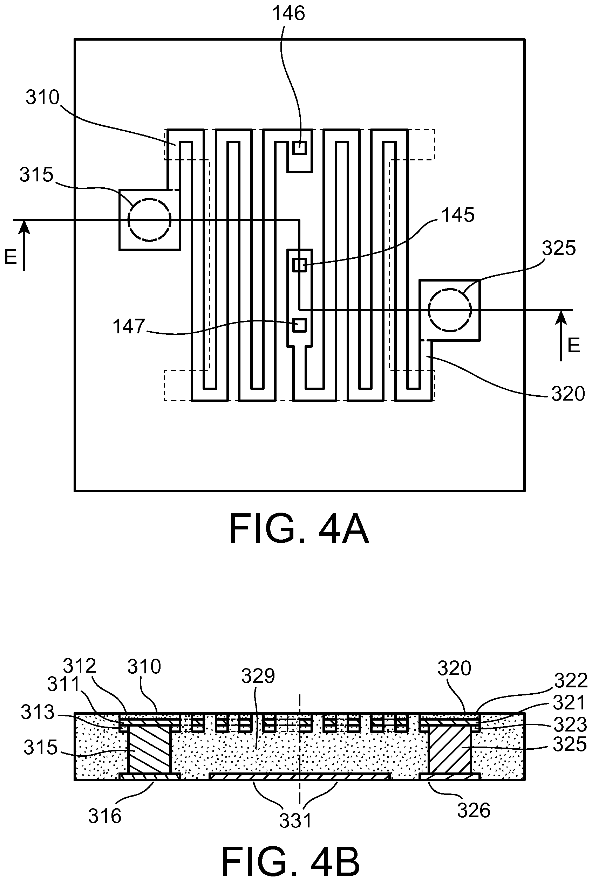

Les figures 4A et 4B illustrent les bras d'isolation 310, 320 en cours de fabrication lors de l'étape de fourniture des bras d'isolation 310, 320. Les premiers et deuxième bras d'isolation 310, 320 sont fournis en contact de la deuxième couche sacrificielle 142.
Ainsi le premier et le deuxième bras d'isolation 310, 320 comporte chacun :

- une première couche de rigidification 312, 322 en contact de la deuxième couche sacrificielle 142,
- la piste de conduction correspondante 311, 321 en contact avec la première couche de rigidification 312, 322 sur la face de la première couche de rigidification 312, 322 qui est opposée à la deuxième couche sacrificielle 142,
- une deuxième couche de rigidification 313, 323 en contact avec la piste de conduction correspondante 311, 321 sur la face de la piste de conduction correspondante 311, 321 qui est opposée à la première couche de rigidification 312, 322.

Le premier et le deuxième bras d'isolation 310, 320 sont configurés pour isoler thermiquement le transistor 100 du reste du composant 1. Ainsi, comme illustré sur la figure 4A, le premier et le deuxième bras d'isolation 310, 320 présentent une longueur maximale pour une largeur et une épaisseur minimales. Ainsi, le premier et le deuxième bras d'isolation 310, 320 se présentent chacun sous la forme d'un serpentin occupant une moitié de la surface de la structure. En variante, d'autres configurations du premier et du deuxième bras d'isolation 310, 320 sont envisageables. Par exemple chacun du premier et du deuxième bras d'isolation 310, 320 peuvent se présenter sous la forme de méandres imbriqués par aboutage de segments perpendiculaires les uns avec les autres.
Les premières et les deuxièmes couches de rigidification 312, 322, 313, 323 du premier et du deuxième bras d'isolation 310, 320 sont réalisées dans un matériau résistant à l'attaque sélective des première et deuxième couches sacrificielles 352, 142. Ainsi, dans une application pratique de l'invention, les premières et les deuxièmes couches de rigidification 312, 322, 313, 323 du premier et du deuxième bras d'isolation 310, 320 peuvent être réalisées en silicium amorphe, alumine $Al_2O_3$ ou en nitrure d'aluminium AlN. La première et la deuxième couches de rigidification 312, 322, 313, 323 du premier et du deuxième bras d'isolation 310, 320 peuvent présenter une épaisseur allant de 10 à 100 nm, préférentiellement de 20 à 60 nm, voire être sensiblement égale à 20 nm, ceci afin d'assurer une rigidité suffisante pour supporter le transistor 100.
La première couche de rigidification 312 du premier bras d'isolation 310 présente, au niveau du deuxième via conducteur 146, une percée dans laquelle est ménagé un premier conducteur afin de mettre en contact la première piste de conduction 311 en contact électrique avec le deuxième via conducteur 146. De la même façon, la première couche de rigidification 322 du deuxième bras d'isolation 320 présente, au niveau du premier et du troisième via conducteur 145, 147, deux percées dans lesquelles sont ménagés un premier et un deuxième conducteur afin de mettre en contact la deuxième piste de conduction 321 en contact électrique avec respectivement le premier et le troisième via conducteur 145, 147.
On peut noter qu'avantageusement, les premier et deuxième conducteurs peuvent formés lors du dépôt de la première piste de conduction 311 par comblement des percées correspondant par le matériau métallique formant la piste conductrice 311.
Selon une possibilité avantageuse de l'invention, les première et deuxième pistes de conduction 311, 321 peuvent être réalisées en nitrure de titane TiN (épaisseur typique 10 nm). De cette manière, le premier et le deuxième bras d'isolation 310, 320 forment un troisième élément absorbant à celui formé par la première électrode de grille 120. En variante, et de la même façon que pour la première électrode de grille 120, la première et la deuxième piste de conduction 311, 321 peuvent être réalisées dans un métal et présenter une épaisseur Ep respectant les inégalités suivantes :

$$150\Omega \leq \frac{\rho}{Ep} \leq 700\,\Omega$$

avec $\rho$ la résistivité du matériau métallique formant ladite piste de conduction 311, 321. Afin de fournir une absorption du rayonnement électromagnétique, cette même piste de conduction 311, 321 peut avantageusement respecter les inégalités suivantes :

$$320\,\Omega \leq \frac{\rho}{Ep} \leq 420\,\Omega$$

De manière encore plus avantageuse $\frac{\rho}{Ep}$ peut être sensiblement égale à 377 Ω, c'est-à-dire compris entre 360 Ω et 380 Ω.

Les deuxièmes couches de rigidification 313, 323 du premier et du deuxième bras d'isolation 310, 320 comportent une première et une deuxième colonne d'espacement 315, 325 en correspondance avec respectivement le premier et deuxième plot de collage 354, 355 du circuit de lecture 340 et en connexion électrique avec la piste de conduction correspondante 311, 321. Dans une application pratique de l'invention, les première et deuxième colonnes d'espacement 315, 325 peuvent présenter, par exemple, un diamètre de 0,7 μm.

La première et la deuxième colonnes d'espacement 315, 325 sont prolongées par respectivement un troisième et un quatrième plot de collage 316, 326. Le troisième et le quatrième plot de collage 316, 326 sont dimensionnés en correspondance avec respectivement le premier et le deuxième plot de collage 354, 355. Ainsi, chacun du troisième et le quatrième plot de collage 316, 326 peut présenter une surface de 1 μm par 1 μm.

Comme illustré sur la figure 4B, le premier et le deuxième bras d'isolation 310, 320 et les première et deuxième colonnes d'espacement sont inclus dans une troisième couche sacrificielle 329 avec les première et deuxième colonnes d'espacement 315, 325 qui font saillie de la couche de rigidification 313, 323. Les première et deuxième colonnes d'espacement s'étendent avec les troisième et quatrième plots de collage 316, 326 sur toute l'épaisseur de la troisième couche sacrificielle 329. Ainsi, le troisième et le quatrième plot de collage 316, 326 affleurent de la troisième couche sacrificielle 329 sur la face de la troisième couche sacrificielle 329 qui est opposée aux premier et deuxième bras d'isolation 310, 320.

La troisième couche sacrificielle 329 et les colonnes d'espacement 315, 325 sont dimensionnées de manière que la surface de réflexion 330, 331 forme avec la première couche d'absorption 210 une cavité quart d'onde.

Une deuxième partie 331 de la surface de réflexion 330, 331 est également incluse dans la troisième couche sacrificielle 329 en affleurant de cette dernière en correspondance de la première partie 330 de la surface de réflexion 330, 331.

La troisième couche sacrificielle 329, afin d'autoriser sa gravure sélective lors de la gravure des première et deuxième couche sacrificielle 352, 142 et un collage moléculaire entre l'ensemble formé par la troisième couche sacrificielle 329, la deuxième partie 331 de la surface de réflexion 330, 331 et les troisième et quatrième plot de connexion 316, 326, et l'ensemble formé par la première couche sacrificielle 352, la première partie de la surface de réflexion 330, 331 et les plots de collage 354, 355.

Ainsi, l'étape de fourniture des bras d'isolation comporte les sous-étapes suivantes :

- dépôt d'une première couche de rigidification pleine plaque en contact de la deuxième couche sacrificielle 142 sur la face de la deuxième couche sacrificielle 142 qui est opposée à la deuxième couche d'arrêt,
- délimitation dans la première couche de rigidification pleine plaque des percées destinées à former les percées des premières couches de rigidification 312, 322 du premier et du deuxième bras d'isolation 310, 320,
- dépôt dans les percées des premier, deuxième et troisième conducteurs,
- dépôt d'une couche conductrice pleine plaque en contact avec la première couche de rigidification pleine plaque sur une face de la première couche de rigidification qui est opposée de la deuxième couche sacrificielle 142,
- dépôt d'une deuxième couche de rigidification pleine plaque en contact de la couche conductrice pleine plaque sur une face de la couche conductrice pleine plaque qui est opposée de la première couche de rigidification pleine plaque,
- gravure sélective de la première couche de rigidification pleine plaque, de la couche conductrice pleine plaque et de la deuxième couche de rigidification pleine plaque de manière à former les premier et deuxième bras d'isolation,
- dépôt de la troisième couche sacrificielle 329 de manière à ce que le premier et le deuxième bras d'isolation 310, 320 soient inclus dans la troisième couche sacrificielle,
- ménagement d'une première et d'une deuxième ouverture dans la troisième couche sacrificielle et dans respectivement des deuxièmes couches de rigidification 313, 323 du premier et du deuxième bras d'isolation 310, 320 afin de permettre la formation des colonnes d'espacement 315, 325 et de troisième et quatrième plots de collage 316, 326,
- ménagement d'une troisième ouverture dans la troisième couche sacrificielle afin de permettre la formation d'une deuxième partie 331 de la surface de réflexion 330, 331,
- dépôt métallique dans les première, deuxième et troisième ouvertures de la troisième couche sacrificielle et dans les première et deuxième ouvertures de chacun des deuxièmes couches de rigidification 313, 323 afin de former les première et deuxième colonnes d'espacement, les troisième et quatrième plots de collage et la deuxième partie 331 de la surface de réflexion 330, 331, la troisième couche sacrificielle 329, la deuxième partie 331 de la surface de réflexion 330, 331 et les plots de collage 315, 325 pouvant être soumises à une sous étape de planarisation afin de favoriser un collage moléculaire

La quatrième étape de collage de l'ensemble transistor 100 /bras d'isolation 310, 320 avec le circuit de lecture 340 permet de former la structure de détection 10 selon l'invention. Lors de cette étape, l'ensemble formé par la troisième couche sacrificielle 329, la deuxième partie 331 de la surface de réflexion 330, 331, et les troisième et quatrième plots de collage 316, 326 est collé moléculairement à l'ensemble formé par la première couche sacrificielle 352, la première partie 330 de la surface de réflexion 330, 331, et les plots de collage 354, 355 avec le premier plot de collage 354 mis en relation de le troisième plot de collage 316 et le deuxième plot de collage 355 mis en relation de le quatrième plot de collage 326.

Une fois le collage moléculaire réalisé et dans le cadre de la variante préférée de l'invention dans laquelle la deuxième électrode de grille n'ont pas été réalisée lors de la deuxième étape, il est prévu des sous-étape supplémentaire pour former la première portion de la couche sacrificielle 142 et la deuxième électrode de grille 130.

Selon cette variante, la première portion de la couche sacrificielle 142 est réalisée dans le même matériau que celui de la deuxième portion de la couche sacrificielle 142 formée lors de la deuxième étape. Ainsi, la première portion de la couche sacrificielle 142 peut être réalisée en alumine $Al_2O_3$ ou en nitrure d'aluminium AIN. La première portion de la couche sacrificielle 142 forme ainsi un isolant électrique pour isoler électriquement la deuxième électrode de grille des première, deuxième et troisième zones 111, 112.

La deuxième électrode de grille 130 est avantageusement réalisée en nitrure de titane TiN avec une épaisseur sensiblement égal à 10 nm. Selon cette possibilité, la deuxième grille 130 forme un quatrième élément absorbant à celui formé par la première électrode de grille 120. De la même façon que pour la première couche d'absorption 210, la deuxième électrode de grille 130 peut également être réalisée dans un métal et présenter une épaisseur Ep respectant les inégalités suivantes :

$$150\Omega \leq \frac{\rho}{Ep} \leq 700\,\Omega$$

avec $\rho$ la résistivité du matériau métallique formant ladite piste de conduction 311, 321. Afin de fournir une absorption du rayonnement électromagnétique, cette même piste de conduction 311, 321 peut avantageusement respecter les inégalités suivantes :

$$320\,\Omega \leq \frac{\rho}{Ep} \leq 420\,\Omega$$

De manière encore plus avantageuse $\frac{\rho}{Ep}$ peut être sensiblement égale à 377 $\Omega$, c'est-à-dire compris entre 360 $\Omega$ et 380 $\Omega$.

De la même façon, dans le cas où la deuxième électrode de grille 130 ne fournit aucune fonction d'absorption du rayonnement électromagnétique, la deuxième grille 130 peut être réalisée dans un autre matériau sans que l'on sorte du cadre de l'invention. Ainsi, il est, par exemple, envisageable qu'une telle deuxième électrode de grille 130 soit réalisée en silicium polycristallin Si. Il est également envisageable que la deuxième électrode de grille 130 soit formée de deux couches conductrices, l'une d'elle pouvant éventuellement être en nitrure de titane TiN.

Ainsi, selon cette variante de l'invention, la quatrième étape comprend en outre les étapes suivantes :

- formation de la première portion deuxième couche d'arrêt 142 en contact avec les première, deuxième et troisième zones 111, 112, 113 sur la face de ces dernières qui est opposée à la première électrode de grille 120,

- ouverture d'un passage traversant 131, illustré sur la figure 1B, dans la première portion de de la deuxième couche sacrificielle 142, ledit passage traversant débouchant dans la deuxième zone 112,

- formation de la deuxième électrode de grille 130 en contact avec la première portion de la deuxième couche sacrificielle 142, un via conducteur étant alors formé dans le passage traversant 131 entre la deuxième électrode de grille 130 et la deuxième zone 112.

Que ce soit dans la variante de préférée décrite ci-dessus ou dans la variante dans laquelle la deuxième électrode de grille 120 est fournie lors de la deuxième étape, la quatrième étape comporte en outre la sous étape suivante de

- gravure sélective des première, deuxième et troisième couches sacrificielles 352, 142, 329, par exemple par une attaque acide, le reste de la structure de détection 10 étant protégée par les première et deuxième couches d'arrêt 351, 141.

De cette manière, le transistor 100 est isolé thermiquement du reste de la structure de détection 10 par le premier et le deuxième bras d'isolation 310, 320.

On notera que cette dernière étape, avec celle de gravure et d'amincissement du substrat, permet, dans le cas où la structure de détection 10 équipe un composant comportant une pluralité de structures de détection 10A, 10B, 10C, 10D , d'isoler thermiquement la structure de détection 10 du circuit de lecture correspondant et des structures de détection 10A, 10B, 10C, 10D qui lui sont directement adjacente.

Ainsi, la figure 5 illustre un exemple d'intégration d'une structure de détection 10 selon l'invention dans un tel composant 1 comportant une pluralité de structures de détection 10A, 10B, 10C, 10D organisées sous la forme d'une matrice carrée. On peut ainsi voir sur la figure 5 que l'agencement des plots de collage 342, 343 en décalé permet d'optimiser la surface occupée par chacune des structures 10A, 10B, 10C, 10D, le premier plot de connexion 342A, 342B, 342C, 342D étant adjacent du deuxième plot de connexion 343A, 343B, 343C, 343D de la structure10A, 10B, 10C, 10D qui lui est directement adjacente sur la gauche, le deuxième plot de connexion 343A, 343B, 343C, 343D étant adjacent du premier plot de connexion 342A, 342B, 342C, 342D de la structure de détection 10A, 10B, 10C, 10D qui lui est directement adjacente sur la droite. Avec une telle configuration, la surface de réception, i.e la surface de la première grille 120, occupe une surface optimisée. Une telle configuration laisse envisager des composants présentant un pas entre deux structures 10A, 10B, 10C, 10D de l'ordre de 5 µm.

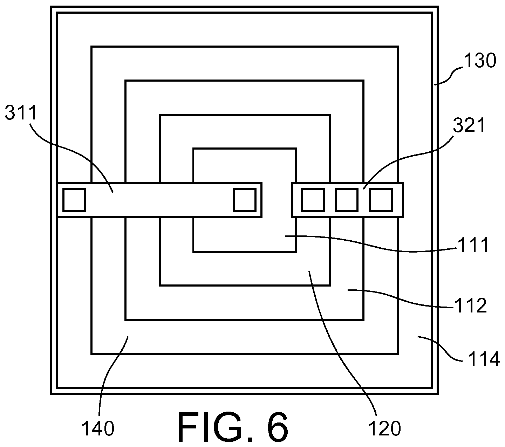

La figure 6 illustre l'agencement de l'électrode de grille d'une structure de détection 10 selon un deuxième mode de réalisation de l'invention dans lequel la surface d'éléments d'absorption est optimisée. Une telle structure de détection 10 se différentie d'une structure de détection 10 selon le premier mode de réalisation en ce que le transistor comporte une premier, deuxième, troisième, quatrième et cinquième zone 111, 112, 113, 114, 115 et une première et troisième électrode de grille 120, 140.

La première, deuxième et troisième zone 111, 112, 113 et la première électrode de grille 120 présentent une configuration identique à celle décrite dans le premier mode de réalisation, à la différence près que, la deuxième zone 112 fait office de drain et c'est donc, de ce fait, elle qui est en court-circuit avec la première électrode de grille 120. Ainsi, la deuxième piste de conduction 321 permet de polariser la deuxième zone 112 et la première électrode de grille 120, la première piste de conduction 311 permettant de polariser la première zone 111.

La quatrième zone 114 est une zone du premier type de conductivité, avec une configuration similaire à celle de la première et la deuxième zone 111, 112. De façon similaire à la troisième zone 113, la cinquième zone 115 peut être une zone totalement déplétée. La cinquième zone 115 entoure la deuxième zone 112 et la quatrième zone 114 entoure la cinquième zone.

La troisième électrode de grille 140 présente une configuration sensiblement identique à celle de la première électrode de grille et comporte ainsi, de la même façon que la première électrode grille, une deuxième couche d'absorption 220

La deuxième piste de conduction 321 est configurée afin de, comme illustré sur la figure 6, mettre en court-circuit la première électrode de grille 120 avec la troisième électrode de grille 140 et avec la deuxième zone 112. La première piste de conduction 311 est configurée afin de, comme illustré sur la figure 6, mettre en court-circuit la première zone 111 avec la quatrième zone 114. De cette manière, la structure présente deux transistors en parallèle l'un de l'autre et présente une surface d'électrode de grille augmentée et un rapport de la largeur de grille à la longueur de grille optimisé.

Bien entendu, si dans le premier et le deuxième mode de réalisation décrits ci-dessus, la première électrode de grille 120 est mise en court-circuit avec l'une de la première et la deuxième zone 111, 112, il est également envisageable, sans que l'on sorte du cadre de l'invention que les première, deuxième zone et la première électrode de grille soit polarisées indépendamment les unes des autres. Dans une telle configuration, il est alors nécessaire de prévoir une troisième piste conductrice fournie soit dans l'un du premier et du deuxième bras d'isolation, soit dans un troisième bras d'isolation. De la même façon, dans le cas où il est prévu une deuxième électrode de grille 130 sur la face des première, deuxième et troisième zones 111, 112, 113 opposée à la première face si cette dernière peut être polarisée au moyen d'une connexion électrique à la deuxième zone 112, il est également envisageable, sans que l'on sorte du cadre de l'invention que la deuxième électrode de grille 130 soit polarisée autrement. Dans une telle configuration, il est nécessaire de prévoir une troisième piste conductrice fournie soit dans l'un du premier et du deuxième bras d'isolation, soit dans un troisième bras d'isolation.

On peut également noter que si dans les modes de réalisation décrits ci-dessus, il est prévu une deuxième électrode de grille 130, une telle deuxième grille 130 n'est pas nécessaire pour le bon fonctionnement de l'invention. Ainsi, il est parfaitement envisageable d'ajuster la tension seuil du transistor au moyen de charges piégées dans l'une de la première et la deuxième couche isolante électriquement ou encore de prévoir une polarisation indépendante de la première électrode de grille 120.

De la même façon, si dans le premier et le deuxième mode de réalisation il est prévu une surface de réflexion 330, 331, il est également envisageable, sans que l'on sorte du cadre de l'invention, que la structure de détection 10 en soit dépourvue.

On peut également noter que la forme des zones et/ou des électrodes de grille décrites dans le cadre du premier et du deuxième mode de réalisation n'est donnée qu'à titre d'exemple et n'est nullement limitative. Ainsi, il est également parfaitement envisageable dans le cadre de l'invention une structure similaire à celle du premier mode de réalisation à la différence près que les première, deuxième et troisième zones se succèdent le long d'une première direction. De la même façon, il est également envisageable une structure similaire à celle du deuxième mode de réalisation à la différence près que les première, deuxième et troisième, quatrième et cinquième zones se succèdent le long d'une première direction.

## Revendications

1. Structure de détection (10) de type bolomètre pour la détection d'un rayonnement électromagnétique, la structure de détection (10) comportant :

    - au moins un premier élément absorbant (210) configuré pour absorber le ayonnement électromagnétique,
- un transistor (100) du type MOS-FET associé avec le premier élément absorbant pour détecter l'élévation de température dudit élément absorbant lors de l'absorption du rayonnement électromagnétique, le transistor comportant :

    o au moins une première et au moins une deuxième zone (111, 112) d'un premier type de conductivité,
    o au moins une troisième zone (113) séparant l'une de l'autre la première et la deuxième zone (111, 112), la troisième zone (113) étant d'un type de conductivité sélectionné dans un groupe comportant un deuxième type de conductivité opposé au premier type de conductivité et un type de conductivité dans lequel la troisième zone (113) est sensiblement vide de porteurs,
    o au moins une première électrode de grille (120) agencée pour polariser la troisième zone (113),

la structure de détection (10) **étant caractérisée en ce que** la première électrode de grille (120) comporte au moins une première portion métallique (210) formant le premier élément absorbant, ladite première portion métallique présentant une épaisseur Ep respectant les inégalités suivantes :

$$150\ \Omega \leq \frac{\rho}{Ep} \leq 700\ \Omega$$

avec $\rho$ la résistivité du matériau métallique formant ladite portion métallique, et
dans laquelle la première zone (111) est entourée par la troisième zone (113), la troisième zone (113) étant entourée par la deuxième zone (112).

2. Structure de détection (10) selon la revendication 1 dans laquelle la première portion métallique de la première électrode de grille est réalisée dans un métal du type « milieu-de-gap » pour la troisième zone, la première portion métallique étant préférentiellement dans un métal choisi dans le groupe comportant les nitrures de titane, les nitrures de tantale et les siliciures de molybdène pour une troisième zone (113) réalisée en silicium, la première portion métallique étant avantageusement réalisée dans un nitrure de titane pour une troisième zone (113) réalisée en silicium.

3. Structure de détection (10) selon la revendication 2 dans laquelle la première électrode de grille (120) est en court-circuit avec l'une de la première et la deuxième zone (111, 112).

4. Structure de détection (10) selon l'une quelconque des revendications 1 à 3, dans laquelle le transistor (100) comporte en outre :

    - une quatrième et cinquième zone (114, 115), la quatrième zone (114) étant du premier type de conductivité et la cinquième zone (115) étant d'un type de conductivité sélectionné dans le groupe comportant un deuxième type de conductivité opposé au premier type de conductivité et un type de conductivité dans lequel la cinquième zone est sensiblement vide de porteurs,
    - une troisième électrode de grille (140) agencée pour polariser la cinquième zone (115),
dans laquelle la cinquième zone (115) sépare l'une de l'autre la deuxième et la quatrième zone (112, 114), un ensemble formé par la troisième, la deuxième et la cinquième zone (113, 112, 115) séparant l'une de l'autre la première et la quatrième zone (111, 114), et dans laquelle la troisième électrode de grille (140) comporte au moins une deuxième portion métallique formant un deuxième élément absorbant, ladite deuxième portion métallique présentant une épaisseur Ep respectant les inégalités suivantes :

$$150\ \Omega \leq \frac{\rho}{Ep} \leq 700\ \Omega$$

avec $\rho$ la résistivité du matériau métallique formant ladite deuxième portion métallique,
dans laquelle la première électrode de grille (120) et la troisième électrode de grille (140) et la deuxième zone (112) sont en court-circuit, et
dans laquelle la première zone 111 et la quatrième zone 114 sont en court-circuit.

5. Structure de détection (10) selon les revendications 1 et 4, dans laquelle la cinquième zone (115) entoure la deuxième zone (112) et dans laquelle la quatrième zone (114) entoure la cinquième zone (115).

6. Structure de détection (10) selon l'une quelconque des revendications 1 à 5, dans laquelle la troisième zone (113) est du type de conductivité dans lequel la troisième zone (113) est sensiblement vide de porteurs.

7. Structure de détection (10) selon l'une quelconque des revendications 1 à 6, dans laquelle il est prévu une surface de réflexion (330, 331) configurée pour former avec le premier élément absorbant une cavité quart d'onde.

8. Structure de détection (10) selon l'une quelconque des revendications 1 à 7 comportant en outre un circuit de lecture (340) configuré pour polariser le transistor (100) et pour déterminer, à partir d'un courant de fonctionnement du transistor (100) une élévation de température de l'élément absorbant, dans laquelle le circuit de lecture (340) et le transistor (100) sont séparés l'un de l'autre par au moins un premier et un deuxième bras d'isolation (310, 320) comportant chacun au moins une piste conductrice (311, 321) pour polariser le transistor (100).

9. Structure de détection (10) selon la revendication 8, dans laquelle chacune des pistes conductrices (311, 321) du premier et deuxième bras d'isolation (310, 320) est une piste métallique formant un troisième élément absorbant et présente une épaisseur Ep respectant les inégalités suivantes :

$$150\,\Omega \le \frac{\rho}{Ep} \le 700\,\Omega$$ avec $\rho$ la résistivité du matériau métallique formant ladite deuxième portion métallique.

10. Structure de détection (10) selon l'une quelconque des revendications 1 à 9, dans laquelle le transistor comporte en outre une deuxième électrode de grille (130) sur une face du transistor qui est opposée à la première électrode de grille (120),
et dans laquelle la deuxième électrode de grille (130) comporte au moins une portion métallique formant un quatrième élément absorbant.

11. Procédé de fabrication d'une structure de détection (10) comportant les étapes suivantes :

- fourniture d'au moins une première, deuxième et troisième zone (111, 112, 113), la première et deuxième zone (111, 112) étant d'un premier type de conductivité, la troisième zone (113) séparant l'une de l'autre la première et la deuxième zone (111, 112) et la troisième zone (113) étant d'un type de conductivité sélectionné dans un groupe comportant un deuxième type de conductivité opposé au premier type de conductivité et un type de conductivité dans lequel la troisième zone est sensiblement vide de porteurs, la première zone (111) étant entourée par la troisième zone (113), la troisième zone (113) étant entourée par la deuxième zone (112),
- formation d'une première électrode de grille (120) agencée pour polariser la troisième zone (113) de manière à former un transistor (100) du type MOS-FET, la première électrode de grille (100) comportant au moins une première portion métallique formant un élément absorbant configuré pour absorber le rayonnement électromagnétique, de cette manière le transistor (100) est associé à l'élément absorbant pour détecter l'élévation de température dudit élément absorbant lors de l'absorption du rayonnement électromagnétique, ladite première portion métallique présentant une épaisseur Ep respectant les inégalités suivantes :

$$150\,\Omega \le \frac{\rho}{Ep} \le 700\,\Omega$$ avec $\rho$ la résistivité du matériau métallique formant ladite portion métallique.

12. Procédé de fabrication selon la revendication 11 dans lequel lors de l'étape de formation de la première électrode de grille (120), la première portion métallique de la première électrode de grille (120) est réalisée dans un métal du type « milieu-de-gap » pour la troisième zone, la première portion métallique étant préférentiellement dans un métal choisi dans le groupe comportant les nitrures de titane, les nitrures de tantale et les siliciures de molybdène pour une troisième zone (113) réalisée en silicium, la première portion métallique étant avantageusement réalisée dans un nitrure de titane pour une troisième zone (113) réalisée en silicium.

13. Procédé de fabrication selon la revendication 11 ou 12 dans lequel il est en outre prévu des étapes de :

- formation d'un circuit de lecture (340) configuré pour polariser le transistor (100) et pour déterminer, à partir d'un courant de fonctionnement du transistor (100) une élévation de température de l'élément absorbant,
- formation d'un premier et d'un deuxième bras d'isolation (310, 320), chacun des premier et deuxième bras d'isolation comportant au moins une piste conductrice (311, 321),
- association ensemble du transistor (100), des premier et deuxième bras d'isolation (310, 320) et du circuit de lecture, de telle façon que le circuit de lecture (340) est connecté électriquement au transistor (100) par l'intermédiaire des pistes conductrices (311, 321) respectives des premier et deuxième bras d'isolation (310, 320).

14. Procédé de fabrication selon la revendication 13 dans lequel lors de l'étape de fourniture du circuit de lecture (340), il est prévu une sous-étape de formation d'une surface de réflexion (330, 331),
et dans laquelle lors de l'étape d'association ensemble du transistor (100), des premier et deuxième bras d'isolation (310, 320) et du circuit de lecture (340), la surface de réflexion (330, 331) présente une disposition de manière à former avec la portion en nitrure de titane de la première électrode de grille (120) une cavité quart d'onde.

**Patentansprüche**

1. Bolometerartige Erfassungsstruktur (10) zum Erkennen von elektromagnetischer Strahlung, wobei die Erfassungsstruktur (10) Folgendes umfasst:

29     **EP 3 516 356 B1**     30

- mindestens ein erstes absorbierendes Element (210), das so konfiguriert ist, dass es die elektromagnetische Strahlung absorbiert,
- einen MOS-FET-Transistor (100), der mit dem ersten absorbierenden Element verbunden ist, um den Temperaturanstieg des absorbierenden Elements bei der Absorption der elektromagnetischen Strahlung zu erkennen, wobei der Transistor Folgendes umfasst:

    o mindestens eine erste und mindestens eine zweite Zone (111, 112) eines ersten Leitfähigkeitstyps,
    o mindestens eine dritte Zone (113), die die erste und die zweite Zone (111, 112) voneinander trennt, wobei die dritte Zone (113) von einem Leitfähigkeitstyp ist, der aus einer Gruppe ausgewählt ist, die einen zweiten Leitfähigkeitstyp, der dem ersten Leitfähigkeitstyp entgegengesetzt ist, und einen Leitfähigkeitstyp umfasst, bei dem die dritte Zone (113) im Wesentlichen frei von Ladungsträgern ist,
    o mindestens eine erste Gate-Elektrode (120), die so angeordnet ist, dass sie die dritte Zone (113) polarisiert, wobei die Erkennungsstruktur (10) **dadurch gekennzeichnet ist, dass** die erste Gate-Elektrode (120) mindestens einen ersten metallischen Abschnitt (210) umfasst, der das erste absorbierende Element bildet, wobei der erste metallische Abschnitt eine Dicke Ep aufweist, die die folgenden Ungleichheiten erfüllt:

$$150 \, \Omega \leq \frac{\rho}{Ep} \leq 700 \, \Omega$$

ten erfüllt: wobei ρ der spezifische Widerstand des metallischen Materials ist, das den metallischen Abschnitt bildet, und

wobei die erste Zone (111) von der dritten Zone (113) umgeben ist, wobei die dritte Zone (113) von der zweiten Zone (112) umgeben ist.

2. Erkennungsstruktur (10) nach Anspruch 1, wobei der erste metallische Abschnitt der ersten Gate-Elektrode für die dritte Zone aus einem Metall vom Typ "Mittelspalt" hergestellt ist, wobei der erste metallische Abschnitt vorzugsweise aus einem Metall hergestellt ist, das aus der Gruppe ausgewählt ist, die Titannitride, Tantalnitride und Molybdänsilizide für eine dritte Zone (113), die aus Silizium hergestellt ist, umfasst, wobei der erste metallische Abschnitt vorteilhafterweise aus einem Titannitrid für eine dritte Zone (113), die aus Silizium hergestellt ist, hergestellt ist.

3. Erkennungsstruktur (10) nach Anspruch 2, wobei die erste Gate-Elektrode (120) mit einer von der ersten und der zweiten Zone (111, 112) kurzgeschlossen ist.

4. Erkennungsstruktur (10) nach einem der Ansprüche 1 bis 3, wobei der Transistor (100) ferner Folgendes umfasst:

    - eine vierte und eine fünfte Zone (114, 115), wobei die vierte Zone (114) vom ersten Leitfähigkeitstyp ist und die fünfte Zone (115) von einem Leitfähigkeitstyp ist, der aus der Gruppe ausgewählt ist, die einen zweiten Leitfähigkeitstyp, der dem ersten Leitfähigkeitstyp entgegengesetzt ist, und einen Leitfähigkeitstyp umfasst, bei dem die fünfte Zone im Wesentlichen frei von Ladungsträgern ist,
    - eine dritte Gate-Elektrode (140), die so angeordnet ist, dass sie die fünfte Zone (115) polarisiert,
wobei die fünfte Zone (115) die zweite und die vierte Zone (112, 114) voneinander trennt, wobei eine durch die dritte, die zweite und die fünfte Zone (113, 112, 115) gebildete Einheit die erste und die vierte Zone (111, 114) voneinander trennt, und wobei die dritte Gate-Elektrode (140) mindestens einen zweiten metallischen Abschnitt umfasst, der ein zweites absorbierendes Element bildet, wobei der zweite metallische Abschnitt eine Dicke Ep aufweist, die die folgenden Ungleichheiten erfüllt: $150 \, \Omega \leq$

$$\frac{\rho}{Ep} \leq 700 \, \Omega$$ wobei ρ der spezifische Widerstand des metallischen Materials ist, das den zweiten metallischen Abschnitt bildet,
wobei die erste Gate-Elektrode (120) und die dritte Gate-Elektrode (140) und die zweite Zone (112) kurzgeschlossen sind, und
wobei die erste Zone (111) und die vierte Zone (114) kurzgeschlossen sind.

5. Erkennungsstruktur (10) nach den Ansprüchen 1 und 4, wobei die fünfte Zone (115) die zweite Zone (112) umgibt und wobei die vierte Zone (114) die fünfte Zone (115) umgibt.

6. Erkennungsstruktur (10) nach einem der Ansprüche 1 bis 5, wobei die dritte Zone (113) vom Leitfähigkeitstyp ist, bei dem die dritte Zone (113) im Wesentlichen frei von Ladungsträgern ist.

7. Erkennungsstruktur (10) nach einem der Ansprüche 1 bis 6, wobei eine reflektierende Oberfläche (330, 331) vorgesehen ist, die so konfiguriert ist, dass sie mit dem ersten absorbierenden Element einen Viertelwellenhohlraum bildet.

8. Erkennungsstruktur (10) nach einem der Ansprüche

16

1 bis 7, ferner umfassend eine Ausleseschaltung (340), die konfiguriert ist, um den Transistor (100) vorzuspannen und aus einem Betriebsstrom des Transistors (100) einen Temperaturanstieg des absorbierenden Elements zu bestimmen, wobei die Leseschaltung (340) und der Transistor (100) durch mindestens einen ersten und einen zweiten Isolationsarm (310, 320) voneinander getrennt sind, die jeweils mindestens eine Leiterbahn (311, 321) zum Vorspannen des Transistors (100) aufweisen.

9. Erkennungsstruktur (10) nach Anspruch 8, wobei jede der Leiterbahnen (311, 321) des ersten und zweiten Isolationsarms (310, 320) eine Metallspur ist, die ein drittes absorbierendes Element bildet und eine Dicke Ep aufweist, die die folgenden Ungleichheiten erfüllt: **150** $\Omega \leq \frac{\rho}{Ep} \leq 700 \ \Omega$ wobei $\rho$ der spezifische Widerstand des metallischen Materials ist, das den zweiten metallischen Abschnitt bildet.

10. Erkennungsstruktur (10) nach einem der Ansprüche 1 bis 9, wobei der Transistor ferner eine zweite Gate-Elektrode (130) auf einer Fläche des Transistors aufweist, die der ersten Gate-Elektrode (120) gegenüberliegt,
und wobei die zweite Gate-Elektrode (130) mindestens einen metallischen Abschnitt aufweist, der ein viertes absorbierendes Element bildet.

11. Verfahren zur Herstellung einer Erkennungsstruktur (10), umfassend die folgenden Schritte:

- Bereitstellen von mindestens einer ersten, zweiten und dritten Zone (111, 112, 113), wobei die erste und zweite Zone (111, 112) von einem ersten Leitfähigkeitstyp sind, die dritte Zone (113) die erste und zweite Zone (111, 112) voneinander trennt und die dritte Zone (113) von einem Leitfähigkeitstyp ist, der aus einer Gruppe ausgewählt ist, die einen zweiten Leitfähigkeitstyp, der dem ersten Leitfähigkeitstyp entgegengesetzt ist, und einen zweiten Leitfähigkeitstyp umfasst, der dem zweiten Leitfähigkeitstyp entgegengesetzt ist, und einen zweiten Leitfähigkeitstyp, der dem dritten Leitfähigkeitstyp entgegengesetzt ist, umfasst, wobei die dritte Zone im Wesentlichen frei von Trägern ist, wobei die erste Zone (111) von der dritten Zone (113) umgeben ist, wobei die dritte Zone (113) von der zweiten Zone (112) umgeben ist,
- Bilden einer ersten Gate-Elektrode (120), die angeordnet ist, um die dritte Zone (113) zu polarisieren, um einen Transistor (100) vom MOS-FET-Typ zu bilden, wobei die erste Gate-Elektrode (100) mindestens einen ersten metallischen Abschnitt umfasst, der ein absorbierendes Element bildet, das konfiguriert ist, um die elektromagnetische Strahlung zu absorbieren, wodurch der Transistor (100) mit dem absorbierenden Element verbunden ist, um den Temperaturanstieg des absorbierenden Elements bei der Absorption der elektromagnetischen Strahlung zu erkennen, wobei der erste metallische Abschnitt eine Dicke Ep aufweist, die die folgenden Ungleichheiten erfüllt: **150** $\Omega \leq$

$$\frac{\rho}{Ep} \leq 700 \ \Omega$$

wobei $\rho$ der spezifische Widerstand des metallischen Materials ist, das den metallischen Abschnitt bildet.

12. Herstellungsverfahren nach Anspruch 11, wobei beim Schritt des Bildens der ersten Gate-Elektrode (120) der erste metallische Abschnitt der ersten Gate-Elektrode (120) aus einem Metall vom Typ "Mittelspalt" für die dritte Zone hergestellt wird, wobei der erste metallische Abschnitt bevorzugt aus einem Metall besteht, das aus der Gruppe ausgewählt ist, die Titannitride,
die Tantalnitriden und die Molybdänsiliziden für eine dritte Zone (113) umfasst, die aus Silizium hergestellt ist, wobei der erste metallische Abschnitt vorteilhafterweise in einem Titannitrid für eine dritte Zone (113), die aus Silizium hergestellt ist, hergestellt ist.

13. Herstellungsverfahren nach Anspruch 11 oder 12, wobei ferner die folgenden Schritte vorgesehen sind:

- Bilden einer Ausleseschaltung (340), die so konfiguriert ist, dass sie den Transistor (100) vorspannt und aus einem Betriebsstrom des Transistors (100) einen Temperaturanstieg des absorbierenden Elements bestimmt,
- Bilden eines ersten und eines zweiten Isolationsarms (310, 320), wobei der erste und der zweite Isolationsarm jeweils mindestens eine Leiterbahn (311, 321) aufweisen,
- Kombinieren des Transistors (100), des ersten und zweiten Isolationsarms (310, 320) und der Leseschaltung, sodass die Leseschaltung (340) mit dem Transistor (100) über die jeweiligen Leiterbahnen (311, 321) des ersten und zweiten Isolationsarms (310, 320) elektrisch verbunden ist.

14. Herstellungsverfahren nach Anspruch 13, wobei bei dem Schritt des Bereitstellens der Leseschaltung (340) ein Unterschritt des Bildens einer reflektierenden Oberfläche (330, 331) vorgesehen ist,
und wobei in dem Schritt des Zusammenfügens des Transistors (100), des ersten und zweiten Isolationsarms (310, 320) und der Leseschaltung (340) die reflektierende Oberfläche (330, 331) eine Anordnung aufweist, um mit dem Titannitridabschnitt der ersten Gateelektrode (120) einen Viertelwellenhohlraum zu bilden.

**Claims**

1. A bolometer-type detection structure (10) for detecting an electromagnetic radiation, the detection structure (10) including:

   - at least one first absorbent element (210) configured to absorb the electromagnetic radiation,
   - a MOSFET-type transistor (100) associated with the first absorbent element to detect the rise in the temperature of said absorbent element upon absorption of the electromagnetic radiation, the transistor including:

     ◦ at least one first and at least one second areas (111, 112) of a first conductivity type,
     ◦ at least one third area (113) separating the first and second areas (111, 112) from one another, the third area (113) being of a conductivity type selected from among a group including a second conductivity type opposite to the first conductivity type and a conductivity type in which the third area (113) is substantially free of carriers,
     ◦ at least one first gate electrode (120) arranged to bias the at least one third area (113),

   the detection structure (10) being **characterised in that** the first gate electrode (120) includes at least one first metal portion (210) forming the first absorbent element,
   said first metal portion having a thickness Ep complying with the following inequalities:

   $$150\Omega \leq \frac{\rho}{Ep} \leq 700\Omega$$ with $\rho$ the resistivity of the metal material forming said metal portion, and
   wherein the first area (111) is surrounded by the third area (113), the third area (113) being surrounded by the second area (112).

2. The detection structure (10) according to claim 1 wherein the first metal portion of the first gate electrode is made in a metal of the "mid-gap" type for the third area, the first metal portion being preferably made in a metal selected from among the group including titanium nitrides, tantalum nitrides and molybdenum silicides for a third area (113) made of silicon, the first metal portion being advantageously made in a titanium nitride for a third area (113) made of silicon.

3. The detection structure (10) according to claim 2 wherein the first gate electrode (120) is in short-circuit with one amongst the first and second areas (111, 112).

4. The detection structure (10) according to any one of claims 1 to 3, wherein the transistor (100) further includes:

   - fourth and fifth areas (114, 115), the fourth area (114) being of the first conductivity type and the fifth area (115) being of the second conductivity type selected from among the group including a second conductivity type opposite to the first conductivity type and a conductivity type in which the fifth area is substantially free of carriers,
   - a third gate electrode (140) arranged to bias the fifth area (115),
   wherein the fifth area (115) separates the second and fourth areas (112, 114) from one another, an assembly formed by the third, second and fifth areas (113, 112, 115) separating the first and fourth areas (111, 114) from one another, and wherein the third gate electrode (140) includes at least one second metal portion forming a second absorbent element, said second metal portion having a thickness Ep complying with the following inequalities:
   $$150\Omega \leq \frac{\rho}{Ep} \leq 700\Omega$$ with $\rho$ the resistivity of the metal material forming said second metal portion,
   wherein the first gate electrode (120) and the third gate electrode (140) and the second area (112) are in short-circuit, and
   wherein the first area 111 and the fourth area 114 are in short-circuit.

5. The detection structure (10) according to claims 1 and 4, wherein the fifth area (115) surrounds the second area (112) and wherein the fourth area (114) surrounds the fifth area (115).

6. The detection structure (10) according to any one of claims 1 to 5, wherein the at least one third area (113) is of the conductivity type in which the third area (113) is substantially free of carriers.

7. The detection structure (10) according to any one of claims 1 to 6, wherein a reflective surface (330, 331) is provided configured to form a quarter-wave cavity with the first absorbent element.

8. The detection structure (10) according to any one of claims 1 to 7 further including a reading circuit (340) configured to bias the transistor (100) and to determine, from an operating current of the transistor (100), a rise in the temperature of the absorbent element,
wherein the reading circuit (340) and the transistor (100) are separated from one another by at least one first and one second insulating arm (310, 320) each including at least one conductive track (311, 321) for biasing the transistor (100).

9. The detection structure (10) according to claim 8, wherein each of the conductive tracks (311, 321) of the first and second insulating arms (310, 320) is a metal track forming a third absorbent element and has a thickness Ep complying with the following inequalities: $150\Omega \leq \frac{\rho}{Ep} \leq 700\Omega$ with $\rho$ the resistivity of the metal material forming said second metal portion.

10. The detection structure (10) according to any one of claims 1 to 9, wherein the transistor further includes a second gate electrode (130) on a face of the transistor that is opposite to the first gate electrode (120), and wherein the second gate electrode (130) includes at least one metal portion forming a fourth absorbent element.

11. A method for manufacturing a detection structure (10) including the following steps:

    - providing at least one first, one second and one third areas (111, 112, 113), the first and second areas (111, 112) being of a first conductivity type, the third area (113) separating the first area and second areas (111, 112) from one another, and the third area (113) being of a conductivity type selected from among a group including a second conductivity type opposite to the first conductivity type and a conductivity type in which the third area is substantially free of carriers, the first area (111) being surrounded by the third area (113), the third area (113) being surrounded by the second area (112),
    - forming a first gate electrode (120) arranged to bias the third area (113) so as to form a MOS-FET-type transistor (100), the first gate electrode (100) including at least one first metal portion forming an absorbent element configured to absorb the electromagnetic radiation, in this manner the transistor (100) is associated with the absorbent element to detect the rise in temperature of said absorbent element upon absorption of the electromagnetic radiation, said first metal portion having a thickness Ep complying with the following inequalities: $150\Omega \leq \frac{\rho}{Ep} \leq 700\Omega$ with $\rho$ the resistivity of the metal material forming said metal portion.

12. The manufacturing method according to claim 11, wherein, during the step of forming the first gate electrode (120), the first metal portion of the first gate electrode (120) is made in a metal of the "mid-gap" type for the third area, the first metal portion being preferably made in a metal selected from among the group including titanium nitrides, tantalum nitrides and molybdenum silicides for a third area (113) made of silicon, the first metal portion being advantageously made in a titanium nitride for a third area (113) made of silicon.

13. The manufacturing method according to claim 11 or 12 wherein the following steps are also provided for:

    - forming a reading circuit (340) configured to bias the transistor (100) and to determine, from an operating current of the transistor (100), a rise in the temperature of the absorbent element,
    - forming first and second insulating arms (310, 320), each of the first and second insulating arms including at least one conductive track (311, 321),
    - associating together the transistor (100), the first and second insulating arms (310, 320) and the reading circuit, such that the reading circuit (340) is electrically connected to the transistor (100) via the respective conductive tracks (311, 321) of the first and second insulating arms (310, 320).

14. The manufacturing method according to claim 13 wherein during the step of forming the reading circuit (340), a sub-step of forming a reflective surface (330, 331) is provided for, and wherein during the step of associating together the transistor (100), the first and second insulating arms (310, 320) and the reading circuit (340), the reflective surface (330, 331) has an arrangement so as to form a quarter-wave cavity with the portion made of titanium nitride of the first gate electrode (120).

FIG. 1A

FIG. 1B

# FIG. 1C

FIG. 2A

FIG. 2B

FIG. 3A

FIG. 3B

146

310

315

E

147

145

325

320

E

# FIG. 4A

312
311
313
315
310
329
320
322
321
323
325

316
331
326

# FIG. 4B

FIG. 5

FIG. 6

## RÉFÉRENCES CITÉES DANS LA DESCRIPTION

**Documents brevets cités dans la description**

- US 7489024 B
- US 20150153236 A
- EP 2995916 A
- WO 2015059227 A
- DE 3001899
- DE 102014221609
- US 20100244029 A

**Littérature non-brevet citée dans la description**

- *IEEE translation on Electron devices*, 2009, vol. 56 (9), 1935-1942